# EUROPEAN PATENT APPLICATION

(11) **EP 3 965 284 A1**
(43) Date of publication of application: **09.03.2022**
(21) Application number: 20819353.2
(22) Date of filing: 19.03.2020
(51) Int. Cl.: H02N 1/00, B81B 3/00, B81C 3/00

(54) **ELECTROSTATIC DEVICE AND METHOD FOR MANUFACTURING ELECTROSTATIC DEVICE**

(30) Priority: 06.06.2019 JP 2019106230
(71) Applicant: The University of Tokyo, Bunkyo-ku, Tokyo 113-8654 (JP); Saginomiya Seisakusho, Inc., Tokyo 165-0033 (JP)
(72) Inventor: TOSHIYOSHI, Hiroshi, Tokyo 113-8654 (JP); HONMA, Hiroaki, Tokyo 113-8654 (JP); MITSUYA, Hiroyuki, Sayama-shi, Saitama 350-1395 (JP)
(74) Representative: Kramer Barske Schmidtchen Patentanwälte PartG mbB
(86) International application number: PCT/JP2020/012458
(87) International publication number: WO 2020/246115

(57) **Abstract**

This vibration-driven energy harvesting element includes a fixed part, a movable part, an elastic support part that is integrally formed with the movable part and that elastically supports the movable part, and a glass base part in which the fixed part and the elastic support part are anodically bonded to each other in a separated state.

## Description

### Technical Field

The present invention relates to an electrostatic device and a method for manufacturing an electrostatic device.

### Background Art

As an electrostatic device, one that is described in Patent Literature 1 has been known, for example. The electrostatic device described in Patent Literature 1 is made of an SOI (Silicon On Insulator) substrate. The SOI (Silicon On Insulator) substrate is composed of a support layer made of silicon, a BOX (Buried Oxide) layer made of silicon oxide (SiO₂) formed on the support layer, and an active layer made of silicon bonded on the BOX layer. An actuator portion or sensor portion of the electrostatic device is formed from the active layer and a base material that supports the actuator portion or sensor portion is formed from the support layer.

### Citation List

### Patent Literature

Patent Literature 1: Japanese Patent Laid-Open No. 2016-59191

### Summary of Invention

### Technical Problem

However, an expensive SOI substrate is used for a substrate for device fabrication in the above described electrostatic device, and therefore the substrate cost has been one of obstructive factors for hindering cost reduction of the electrostatic device.

### Solution to Problem

According to a first aspect of the present invention, an electrostatic device includes: a fixed portion; a moveable portion; an elastically-supporting portion formed integrally with the moveable portion and elastically supporting the moveable portion; and a base portion made of glass to which the fixed portion and the elastically-supporting portion are anodically bonded in a state in which the fixed portion and the elastically-supporting portion are separated from each other.

Preferably, according to a second aspect of the present invention, in the electrostatic device according to the first aspect, the fixed portion and the moveable portion are formed of silicon, and an electret is formed on at least one of the fixed portion and the moveable portion.

Preferably, according to a third aspect of the present invention, in the electrostatic device according to the second aspect, a fixed electrode is formed in the fixed portion, a moveable electrode facing the fixed electrode is formed in the moveable portion, and the moveable portion is displaced relative to the fixed portion such that capacitance changes between the fixed electrode and the moveable electrode and electricity is generated.

A method for manufacturing an electrostatic device according to a fourth aspect of the present invention is a method for manufacturing an electrostatic device according to any one aspect of the first to third aspects, including: forming the fixed portion, the moveable portion, and the elastically-supporting portion on a substrate in an integral manner; anodically bonding the base portion to the substrate to fix the fixed portion and the elastically-supporting portion on the base portion; and performing etching on the substrate to separate the fixed portion and the elastically-supporting portion from each other.

### Advantageous Effect of Invention

According to the present invention, costs of the electrostatic device can be reduced.

### Brief Description of Drawings

[Figure 1] Figure 1 is a plan view of a vibration-driven energy harvesting element.
[Figure 2] Figure 2 provides views illustrating an A-A cross section and a B-B cross section of Figure 1.

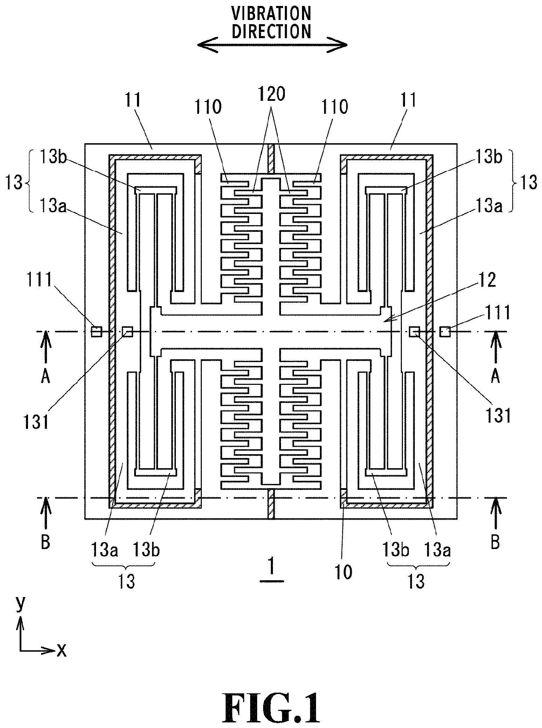

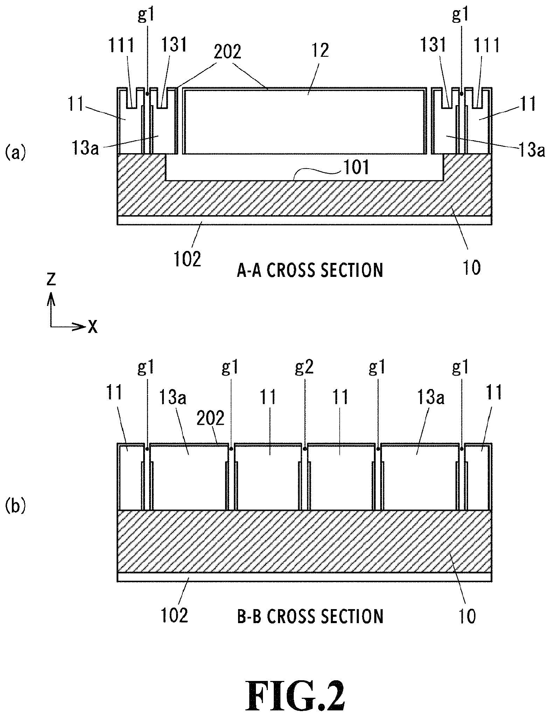

Figure 2 is a diagram showing a cross section taken along the line A-A and a cross section taken along the line B-B in Figure 1.

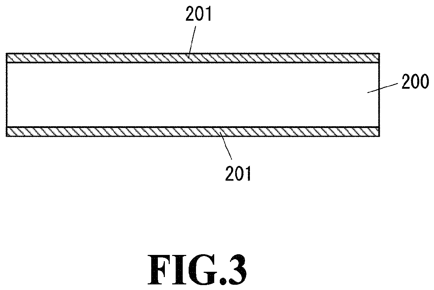

[Figure 3] Figure 3 is a view for explaining a first step.

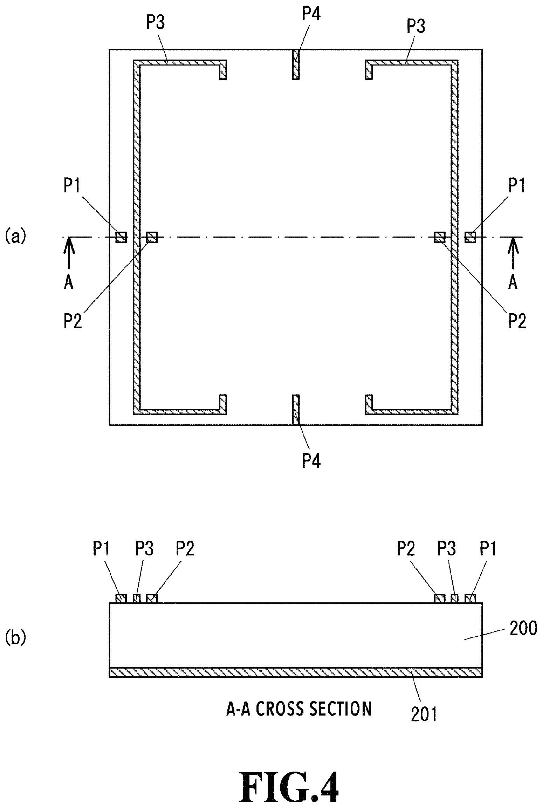

[Figure 4] Figure 4 is a view for explaining a second step.

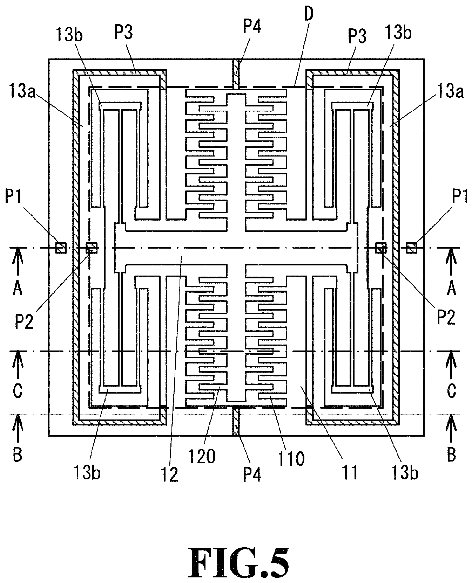

[Figure 5] Figure 5 is a view for explaining a third step.

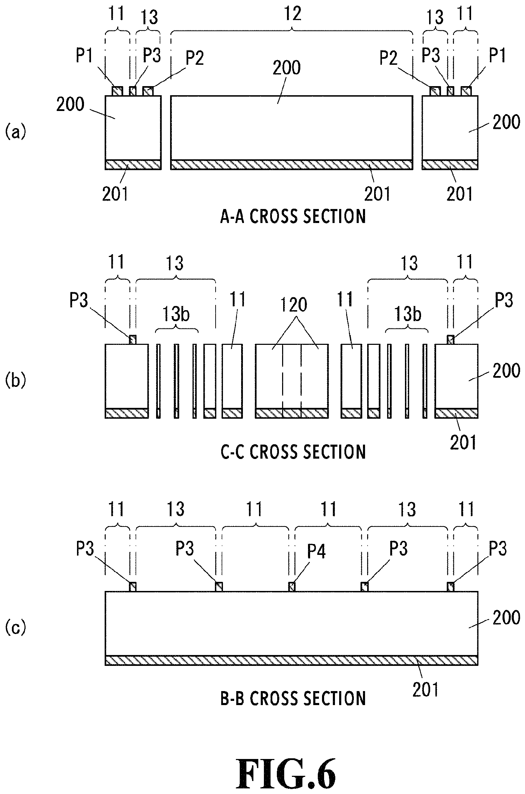

[Figure 6] Figure 6 provides views illustrating an A-A cross section, a B-B cross section, and a C-C cross section of Figure 5.

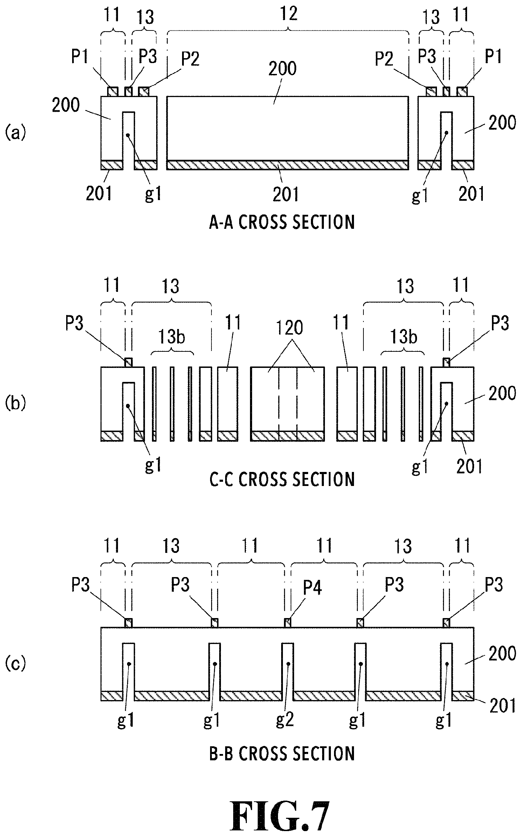

[Figure 7] Figure 7 is a view for explaining a fourth step.

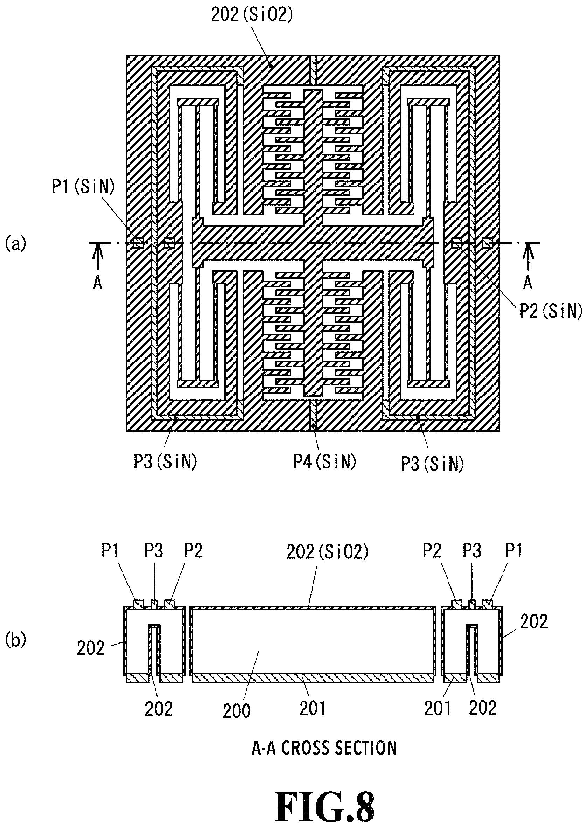

[Figure 8] Figure 8 is a view for explaining a fifth step.

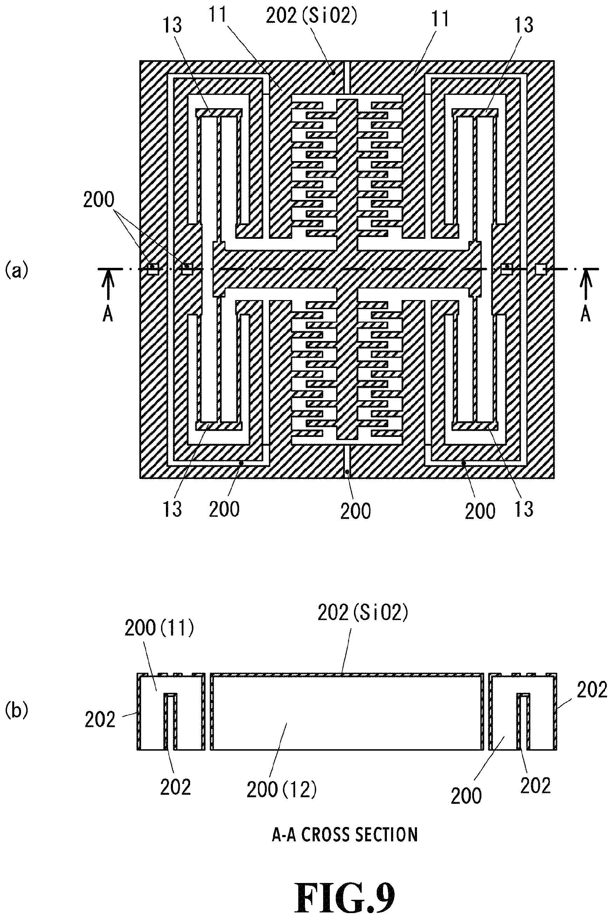

[Figure 9] Figure 9 is a view for explaining a sixth step.

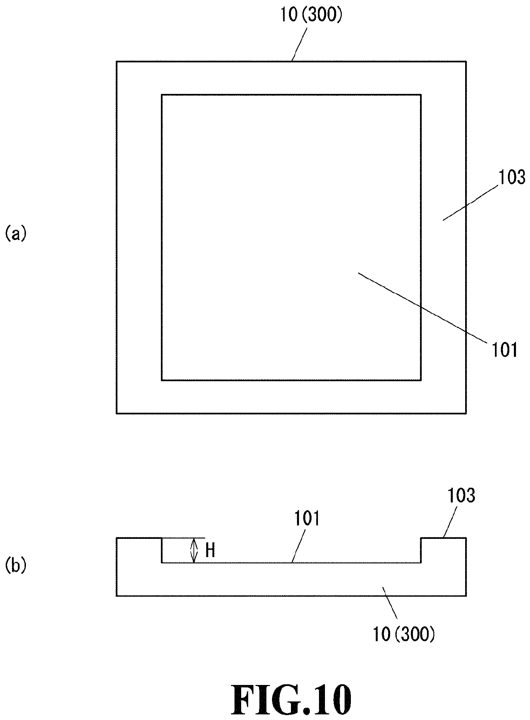

[Figure 10] Figure 10 is a view for explaining a seventh step.

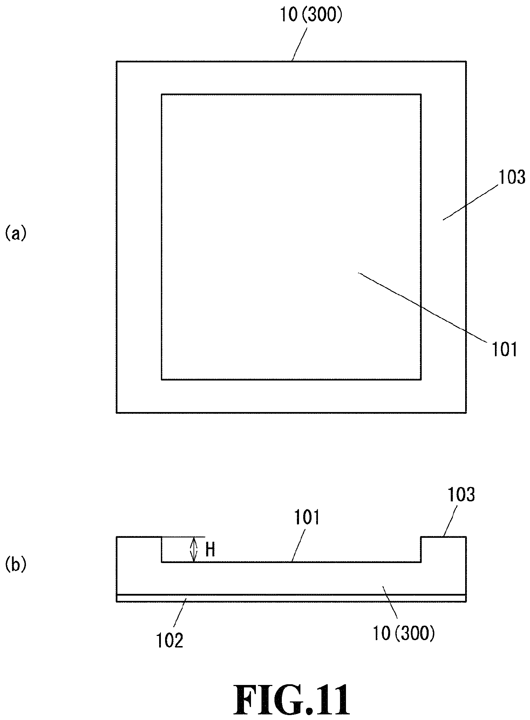

[Figure 11] Figure 11 is a view for explaining an eighth step.

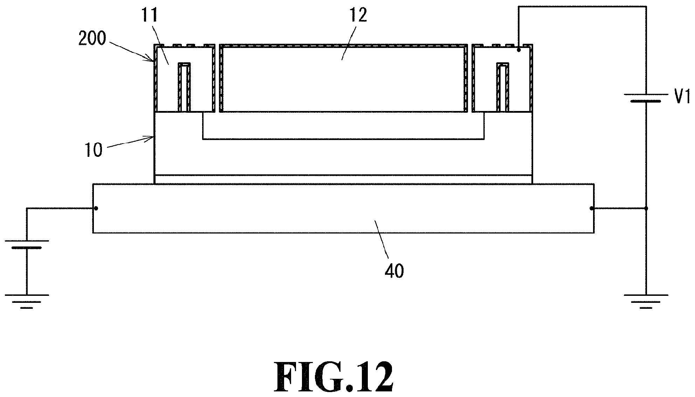

[Figure 12] Figure 12 is a view for explaining a ninth step.

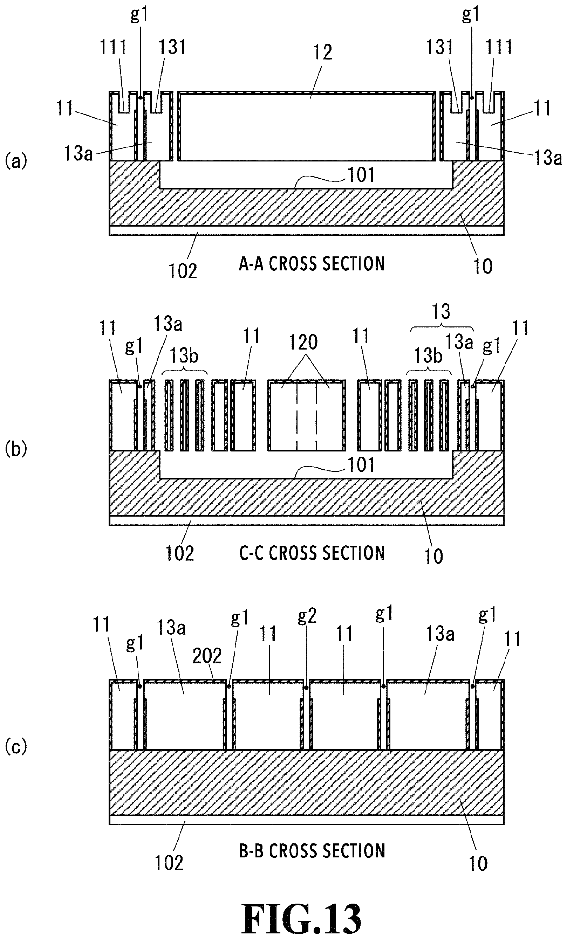

[Figure 13] Figure 13 is a view for explaining a tenth step.

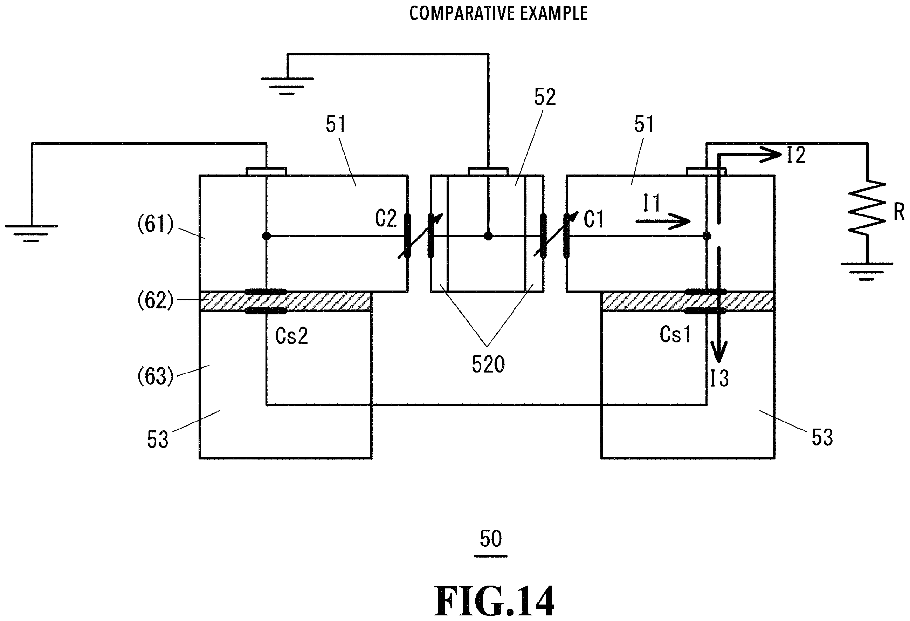

[Figure 14] Figure 14 is a view of a Comparative Example.

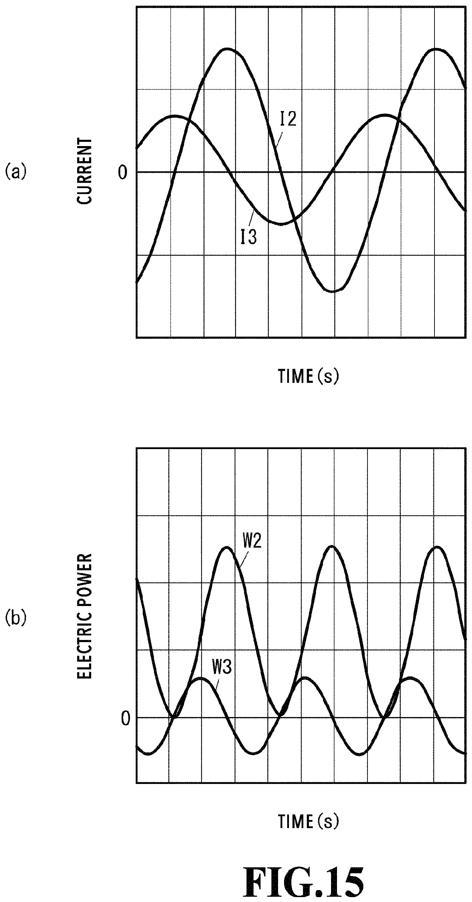

[Figure 15] Figure 15 provides graphs representing results of simulation of vibration-driven energy harvesting in the Comparative Example: the view (a) represents electric current, and the view (b) represents electric power.

### Description of Embodiments

Modes for implementing the present invention will now be described with reference to the drawings. Figure 1 illustrates an example of an electrostatic device and is a plan view of an electrostatic vibration-driven energy harvesting element 1. The vibration-driven energy harvesting element 1 includes a base portion 10, a fixed portion 11 provided on the base portion 10, and a moveable portion 12. There is a right-and-left pair of the fixed portions 11, each of which includes a plurality of comb electrodes 110 formed thereon. The moveable portion 12 located between the pair of fixed portions 11 also includes a plurality of comb electrodes 120 formed thereon. The comb electrodes 120 and the comb electrodes 110 are positioned to face each other so as to interdigitate with each other.

The moveable portion 12 is supported by 4 sets of elastically-supporting portions 13, and the moveable portion 12 vibrates in a right-left direction in the figure (x-direction) when the vibration-driven energy harvesting element 1 is subjected to an external force. Each elastically-supporting portion 13 includes a fixed area 13a fixed on the base portion 10, and an elastic portion 13b that joins the fixed area 13a with the moveable portion 12. At least one of either comb electrodes 110 or comb electrodes 120 includes electrets formed thereon, and electricity is generated in response to a change in the amount of interdigitation between the comb electrodes 110 and the comb electrodes 120 when the moveable portion 12 vibrates in the right-left direction in the figure. The fixed portion 11 includes an electrode pad 111 formed thereon, and similarly an electrode pad 131 is formed on the fixed area 13a of the elastically-supporting portion 13. Generated electricity is to be output from the electrode pads 111, 131.

Figure 2 illustrates cross sections of Figure 1: the view (a) in Figure 2 illustrates an A-A cross section, and the view (b) in Figure 2 illustrates a B-B cross section. The fixed portion 11, the moveable portion 12, and the elastically-supporting portion 13 are formed of an Si substrate, and SiO₂ films 202 that contain alkali metal ions such as potassium are formed on surfaces of the fixed portion 11, the moveable portion 12, and the elastically-supporting portion 13. The electret is formed in the SiO₂ film 202. The fixed portion 11 and the fixed area 13a of the elastically-supporting portion 13 are anodically bonded on the base portion 10 formed of a glass substrate. A recess 101 is formed in the base portion 10.

The fixed portion 11 and the fixed area 13a are separated from each other by a separating groove g1, and the fixed portion 11 is electrically isolated from the elastically-supporting portion 13 and the moveable portion 12. A separating groove g2 illustrated in the view (b) in Figure 2 is one for electrically separating the right-and-left pair of fixed portions 11. The moveable portion 12 is elastically supported above the recess 101 by the elastically-supporting portion 13. A metal layer 102 is formed on a back face of the base portion 10. The comb electrodes 110 of the fixed portion 11 are also located above the recess 101 so as to interdigitate with the comb electrodes 120 of the moveable portion 12.

### (Method For Manufacturing Vibration-driven energy harvesting element 1)

Figures 3 to 16 illustrate an example procedure of manufacturing the vibration-driven energy harvesting element 1. In a first step illustrated in Figure 3, SiN films 201 are formed by means of LP-CVD on both front and back faces of the Si substrate 200. Figure 4 provides views for explanation of a second step: the view (a) in Figure 4 is a plan view, and the view (b) in Figure 4 is an A-A cross-sectional view. In the second step, the SiN film 201 on the front face side is subjected to dry etching to form patterns P1, P2 for forming electrode pads 111, 113 and patterns P3, P4 for forming separating grooves g1, g2.

Figures 5 and 6 illustrate a third step for explanation: Figure 5 illustrates a plan view, the view (a) in Figure 6 illustrates an A-A cross-sectional view, the view (b) in Figure 6 illustrates a C-C cross-sectional view, and the view (c) in Figure 6 illustrates a B-B cross-sectional view. In the third step, Al (aluminum) mask patterns (not illustrated) are formed on the front face side of the Si substrate 200 for forming the fixed portion 11, the moveable portion 12, and the elastically-supporting portion 13, and the Al mask patterns are used to perform etching through the Si substrate 200 and the SiN film 201 by means of Deep-RIE. In this etching, structures of the fixed portion 11, the moveable portion 12, and the elastically-supporting portion 13 that are included in an area D illustrated in Figure 5 are formed. Specifically, portions of the fixed portion 11 and the moveable portion 12 where the comb electrodes 110, 210 are formed and the elastically-supporting portion 13 are formed. The area D in Figure 5 represents an area above the recess 101 in Figure 2.

Figure 7 provides views for explanation of a fourth step: the view (a) in Figure 7 illustrates an A-A cross-sectional view, the view (b) in Figure 7 illustrates a C-C cross-sectional view, and the view (c) in Figure 7 illustrates a B-B cross-sectional view. In the fourth step, etching is performed to form the separating grooves g1, g2 by means of Deep-RIE. The separating grooves g1, g2 are formed in positions of the patterns P3, P4 (see Figure 4). In the fourth step, however, etching is performed to a certain depth in such a way that the separating grooves g1, g2 are not completely separated and the entire Si substrate 200 from the substrate back face side is kept integral (so called half etching).

Figure 8 provides views for explanation of a fifth step: the view (a) in Figure 8 illustrates a plan view, and the view (b) in Figure 8 illustrates an A-A cross-sectional view. In the fifth step, the SiO₂ films 202 that contain alkali metal ions such as potassium are formed on exposed surfaces of the Si substrate 200.

Figure 9 provides views for explanation of a sixth step: the view (a) in Figure 9 illustrates a plan view, and the view (b) in Figure 9 illustrates an A-A cross-sectional view. In the sixth step, the SiN film 201 on the back face of the substrate is first removed by RIE using CF₄ gas. Similarly, the SiN film 201 on the front face side of the substrate is removed.

Figure 10 provides views for explanation of a seventh step: the view (a) in Figure 10 illustrates a plan view, and the view (b) in Figure 10 illustrates a cross-sectional view. In the seventh step, the recess 101 is formed in a glass substrate 300 for forming the base portion 10. A step height H between a bottom surface of the recess 101 and an end face of the frame portion 103 is set to such a dimension that interference of the moveable portion 12 is avoided when it is vibrating (for example, tens of micrometres). A glass substrate used for anodic bonding (for example, a sodium-containing glass substrate) is used for the glass substrate 300.

Figure 11 provides views for explanation of an eighth step: the view (a) in Figure 11 illustrates a plan view, and the view (b) in Figure 11 illustrates a sectional view. In the eighth step, the metal layer 102 such as aluminum deposited film is formed on the back face side of the base portion 10. The metal layer 102 on the back face side is formed for dispersing an electric field to the entire surface of the glass substrate 300 during an anodic bonding process. However, the anodic bonding is achievable without the metal layer 102, and therefore the metal layer 102 is not essential.

In a ninth step illustrated in Figure 12, the base portion 10 composed of the glass substrate illustrated in Figure 11 is anodically bonded to the back face side of the Si substrate 200 in which the fixed portion 11, the moveable portion 12, and the elastically-supporting portion 13 are formed (see Figure 9). The base portion 10 is placed on a heater 40, and the Si substrate 200 in which the fixed portion 11, the moveable portion 12, and the elastically-supporting portion 13 are formed is stacked on the base portion 10. Temperature of the heater 40 is set to a temperature at which thermal diffusion of sodium ions in the glass substrate is sufficiently active (for example, 500°C or higher). Voltage V1 of the Si substrate 200 with reference to the heater 40 is set to, for example, 400 V or higher.

In anodically bonding the silicon substrate (Si substrate 200) and the glass substrate (base portion 10), while the stack of the silicon substrate and the glass substrate is heated, a DC voltage of hundreds of volts is applied to the stack with the silicon substrate side being an anode. Sodium ions in the glass substrate move to the negative potential side, and an SiO⁻ space charge layer (a layer depleted of sodium ions) is formed in an interface on the glass substrate side between the glass substrate and the silicon substrate. The resultant electrostatic attraction causes the glass substrate and the silicon substrate to be bonded.

Figure 13 provides views for explanation of a tenth step: the view (a) in Figure 13 illustrates an A-A cross-sectional view, the view (b) in Figure 13 illustrates a C-C cross-sectional view, and the view (c) in Figure 13 illustrates a B-B cross-sectional view. In the tenth step, the Si substrate 200 anodically bonded to the base portion 10 is subjected to etching by means of Deep-RIE partway to open the separating grooves g1, g2 illustrated in Figure 7, which are left unpenetrated, through from front to back of the Si substrate 200. This completely separates the fixed portion 11 from the elastically-supporting portion 13 that elastically supports the moveable portion 12. Note that in this etching, hole-shaped electrode pads 111, 131 are also formed, in addition to the fact that the separating grooves g1, g2 are opened through.

Thereafter, electrets are formed on at least one of either comb electrodes 110 or comb electrodes 120 according to a known method for forming electrets, for example, the Bias-Temperature method described in Japanese Patent Laid-Open No. 2013-13256 to complete the vibration-driven energy harvesting element 1 in Figure 1.

The vibration-driven energy harvesting element 1 of the embodiment is configured such that the fixed portion 11, the moveable portion 12, and the elastically-supporting portion 13 are formed in a silicon substrate, and the fixed portion 11 and the elastically-supporting portion 13 are fixed to the base portion 10 formed of a glass substrate. Accordingly, cost reduction can be achieved because an expensive SOI substrate as in the electrostatic device described in Patent Literature 1 is not used.

### (Comparative Example)

Figure 14 illustrates a Comparative Example. A vibration-driven energy harvesting element 50 of the Comparative Example is formed by using an SOI substrate. A fixed portion 51, a moveable portion 52, and an elastically-supporting portion 13 that is not illustrated of the vibration-driven energy harvesting element 50 are formed in an active layer 61, which is an upper silicon layer of the SOI substrate, and a base portion 53 is formed in a support layer 63, which is a lower silicon layer. Electrets 520 are formed on comb electrodes of the moveable portion 52. Since an active layer 61 and a support layer 63 are disposed with a BOX layer 62 composed of SiO₂ interposed therebetween, stray capacitances Cs1, Cs2 generated between the active layer 61 and the support layer 63 may adversely affect electric power generated by the vibration-driven energy harvesting element 50.

When the moveable portion 52 vibrates in the right-left direction in the figure relative to the fixed portion 51, capacitances C1, C2 between comb electrodes of the fixed portion 51 and the moveable portion 52 are changed and an AC current due to a change in capacitances C1, C2 is output as a terminal current I1. In the output terminal current I1, a part of currents 13 flows through the stray capacitances Cs1, Cs2, and the rest of currents 12 flows through a load resistance R connected to the vibration-driven energy harvesting element 50.

Figure 15 represents results of simulation of power generation by the vibration-driven energy harvesting element 50: the view (a) in Figure 15 represents currents 12, 13, and the view (b) in Figure 15 represents power W2 consumed in the load resistance R and power W3 moving in and out of the stray capacitance Cs1. The phase of the current through the stray capacitance Cs1 leads a terminal voltage by 90 degrees. The power W3 moving in and out of the stray capacitance Cs1 is a reactive power that is not drawn out to the outside. The same applies to the power moving in and out of the stray capacitance Cs2. As the stray capacitances Cs1, Cs2 increase, the reactive power W3 increases and the active power W2, which is a power consumed in the load resistance R, decreases.

On the other hand, in the vibration-driven energy harvesting element 1 of the embodiment, since the fixed portion 11 and the moveable portion 12 that are formed of silicon are bonded to the base portion 10 formed of the glass substrate, it is possible to prevent generation of the stray capacitance. As a result, it is possible to prevent generation of reactive power caused by the stray capacitance and allow generated electric power to be consumed in the load resistance R without waste.

Note that even in a case of the vibration-driven energy harvesting element 50 formed from the SOI substrate, it is possible to reduce the reactive power as in the case in which the base portion 10 made of the glass substrate is used by making a thickness of the BOX layer smaller than that of a prior art to reduce the stray capacitance.

Advantageous effects of the embodiment described above may be summarized as follows.

(1) The vibration-driven energy harvesting element 1, which is an electrostatic device, includes as illustrated in Figure 1: a fixed portion 11; a moveable portion 12; an elastically-supporting portion 13 formed integrally with the moveable portion 12 and elastically supporting the moveable portion 12; and a base portion 10 made of glass to which the fixed portion 11 and the elastically-supporting portion 13 are anodically bonded in a state in which the fixed portion 11 and the elastically-supporting portion 13 are separated from each other. Accordingly, cost reduction can be achieved comparing to the vibration-driven energy harvesting element 50 fabricated by using the SOI substrate.

In the embodiment described above, although the vibration-driven energy harvesting element 1, which is an electrostatic device, has been taken as an example for explanation, the present invention is not limited to the vibration-driven energy harvesting element 1 and may be applied to an actuator or a sensor as those described in Patent Literature 1. Specifically, such an actuator or a sensor is to be configured such that it is made from a silicon substrate and supported by a base portion made of glass. In this way, in addition to cost reduction, it is possible to reduce the stray capacitance. Instead of a silicon substrate, any other glass substrate or a glass substrate on which a silicon thin film is formed may be used to form an actuator or a sensor, provided that the substrate is electrically conductive and has a coefficient of linear expansion that sufficiently matches with that of the glass substrate.

(2) Further, the fixed portion 11 and the moveable portion 12 may be formed of silicon, and an electret may be formed on at least one of the fixed portion 11 and the moveable portion 12.

(3) In the vibration-driven energy harvesting element 1, which is an electrostatic device, illustrated in Figure 1, a comb electrode 110, which is a fixed electrode, is formed in the fixed portion 11, a comb electrode 120, which is a moveable electrode, facing the comb electrode 110 is formed in the moveable portion 12, an electret is formed on at least one of the fixed portion 11 and the moveable portion 12, and the moveable portion 12 is displaced relative to the fixed portion 11 such that capacitance changes between the comb electrodes 110 and the comb electrodes 120 and electricity is generated. Since the base portion 10 is made of glass, in addition to cost reduction as described above, it is possible to prevent generation of the stray capacitances Cs1, Cs2 in the vibration-driven energy harvesting element 50 illustrated in Figure 14 for which the SOI substrate is used, and prevent generation of the reactive power W3 caused by the stray capacitance.

(4) In a method for manufacturing the electrostatic device described above, the fixed portion 11, the moveable portion 12, and the elastically-supporting portion 13 are formed on a substrate, for example, the Si substrate 200, in an integral manner, the base portion 10 made of glass are anodically bonded to the Si substrate 200 to fix the fixed portion 11 and the elastically-supporting portion 13 on the base portion 10 made of glass, and etching is performed on the Si substrate 200 to separate the fixed portion 11 and the elastically-supporting portion 13 from each other to electrically separate the fixed portion 11 from the moveable portion 12.

As described above, before the fixed portion 11 and the elastically-supporting portion 13 are separated, the Si substrate 200 on which the fixed portion 11, the moveable portion 12, and the elastically-supporting portion 13 are integrated is anodically bonded to the base portion 10 and separation is performed after the anodic bonding. Accordingly, the fixed portion 11, the moveable portion 12, and the elastically-supporting portion 13 can be bonded to the base portion 10 while their positional relation is maintained on a wafer level.

The present invention is not limited to the content of the embodiment described above and any other aspects conceivable within the scope of technical ideas of the present invention are also within the scope of the present invention.

The disclosed contents of the following priority basic applications and patent publications are incorporated herein by reference.
Japanese Patent Application No. 2019-106230 (filed on June, 6, 2019)
Japanese Patent Laid-Open No. 2013-13256

### Reference Signs List

1, 50...vibration-driven energy harvesting element, 10, 53...base portion, 11, 51...fixed portion, 12, 52...moveable portion, 13...elastically-supporting portion, 13a...fixed area, 13b...elastic portion, 40...heater, 110, 120...comb electrodes, 200...Si substrate, 300...glass substrate, Cs1, Cs2...stray capacitance

## Claims

1. An electrostatic device, comprising:
a fixed portion;
a moveable portion;
an elastically-supporting portion formed integrally with the moveable portion and elastically supporting the moveable portion; and
a base portion made of glass to which the fixed portion and the elastically-supporting portion are anodically bonded in a state in which the fixed portion and the elastically-supporting portion are separated from each other.

2. The electrostatic device according to claim 1, wherein
the fixed portion and the moveable portion are formed of silicon, and
an electret is formed on at least one of the fixed portion and the moveable portion.

3. The electrostatic device according to claim 2, wherein
a fixed electrode is formed in the fixed portion,
a moveable electrode facing the fixed electrode is formed in the moveable portion, and
the moveable portion is displaced relative to the fixed portion such that capacitance changes between the fixed electrode and the moveable electrode and electricity is generated.

4. A method for manufacturing the electrostatic device according to any one of claims 1 to 3, the method comprising:
forming the fixed portion, the moveable portion, and the elastically-supporting portion on a substrate in an integral manner;
anodically bonding the base portion to the substrate to fix the fixed portion and the elastically-supporting portion on the base portion; and
performing etching on the substrate to separate the fixed portion and the elastically-supporting portion from each other.
